# FASCICULE DE BREVET EUROPEEN

(11) **EP 1 454 394 B1**
(45) Date de publication et mention de la délivrance du brevet: **31.08.2011**
(21) Numéro de dépôt: 02801122.9
(22) Date de dépôt: 12.12.2002
(51) Int. Cl.: H01S 3/02, H01S 3/06, H01S 3/0941, H01S 5/183

(54) **DISPOSITIF D'EMISSION DE LUMIERE A MICRO-CAVITE ET PROCEDE DE FABRICATION DE CE DISPOSITIF**
LICHT EMITTIERENDE VORRICHTUNG MIT EINEM MIKRORESONATOR UND HERSTELLUNGSVERFAHREN
MICRO-CAVITY LIGHT EMITTING DEVICE AND METHOD FOR MAKING SAME

(30) Priorité: 13.12.2001 FR 0116119
(43) Date de publication de la demande: 08.09.2004
(73) Titulaire: Commissariat à l'Énergie Atomique et aux Énergies Alternatives, 75015 Paris (FR)
(72) Inventeur: PICARD, Emmanuel, F-38410 Saint Martin d'Uriage (FR)
(74) Mandataire: Poulin, Gérard
(86) Numéro de dépôt international: PCT/FR2002/004320
(87) Numéro de publication internationale: WO 2003/050927

(56) Documents cités:
- EP-A- 0 803 946
- DE-A- 19 523 267
- US-A- 5 754 578
- US-A- 5 982 802
- JAYARAMAN V ET AL: "CONTINUOUS-WAVE OPERATION OF SINGLE-TRANSVERSE-MODE 1310-NM VCSELS UP TO 115 øC" IEEE PHOTONICS TECHNOLOGY LETTERS, IEEE INC. NEW YORK, US, vol. 12, no. 12, 1 décembre 2000 (2000-12-01), pages 1595-1597, XP000981099 ISSN: 1041-1135
- HADJI E ET AL: "PHOTOPUMPED INFRARED VERTICAL-CAVITY SURFACE-EMITTING LASER" APPLIED PHYSICS LETTERS, AMERICAN INSTITUTE OF PHYSICS. NEW YORK, US, vol. 68, no. 18, 29 avril 1996 (1996-04-29), pages 2480-2482, XP000588279 ISSN: 0003-6951

## Description

### DOMAINE TECHNIQUE

La présente invention concerne un dispositif d'émission de lumière à micro-cavité ainsi qu'un procédé de fabrication de ce dispositif, ce dernier comprenant une structure émettrice qui est photo-pompée grâce à une diode laser.

L'invention concerne plus particulièrement un dispositif d'émission de lumière à micro-cavité, dans le domaine infrarouge moyen, qui va de 2 µm à 6 µm, et un procédé de fabrication d'un tel dispositif.

L'invention s'applique notamment
- à la détection de gaz, plus particulièrement dans le domaine de l'industrie automobile (mesure de la concentration de gaz d'échappement) et dans le domaine de la climatologie (mesure du dioxyde de carbone dans l'atmosphère), et
- au tri automatique des plastiques qui absorbent également dans l'infrarouge à des longueurs d'ondes différentes selon leur composition.

### ETAT DE LA TECHNIQUE ANTERIEURE

Un dispositif d'émission de lumière à micro-cavité, dans le domaine infrarouge moyen, comprend généralement une partie active en CdHgTe, qui est insérée dans une micro-cavité. Cette dernière est délimitée par deux miroirs de Bragg qui sont rapportés sur la partie active.

La longueur de la micro-cavité est très faible, de l'ordre de quelques demi-longueurs d'onde, et détermine la longueur d'onde de la lumière émise.

Dans un tel dispositif d'émission de lumière, l'excitation de la structure émettrice doit être la plus intense possible. On connaît deux techniques d'excitation permettant d'obtenir des densités de puissance d'excitation supérieures à 100W/cm².

La première de ces techniques consiste à photo-pomper la structure émettrice du dispositif par un laser émettant un faisceau lumineux dont la divergence est très faible. A ce sujet, on se reportera par exemple au document suivant :
C. Roux et al., Appl. Phys. Lett., Vol.75, N°12, 1999, pp. 1661-1663.

Cependant, le montage du laser par rapport à la structure émettrice est encombrant et coûteux.

La deuxième technique connue consiste à photo-pomper cette structure émettrice par une diode laser émettant un faisceau lumineux de grande divergence, qui est focalisé par un montage optique approprié. A ce sujet, on pourra se reporter à un bulletin technique de la Société Nanolase, intitulé "Technology and Applications". La focalisation du faisceau lumineux émis par la diode laser est nécessaire du fait que la densité de puissance dans ce faisceau diminue très rapidement en fonction de la distance.

Cette focalisation est obtenue en insérant, entre la diode de pompage et la structure émettrice, des moyens optiques appropriés (optique de collection et lentille de focalisation) que l'on doit aligner par rapport à la diode et à la structure émettrice.

Cependant, cet alignement augmente considérablement la difficulté de fabrication et le coût du dispositif.

On se reportera également au document suivant :
E. Hadji et al., Optics Lett., Vol. 25, N°10, 2000, pp. 725-727.

Le dispositif divulgué par ce document nécessite également un alignement précis d'une structure émettrice, d'une diode laser et d'une lentille comprise entre ces dernières.

### EXPOSÉ DE L'INVENTION

La présente invention a pour but de remédier aux inconvénients précédents.

L'invention propose un dispositif d'émission de lumière à micro-cavité, dont on pompe la structure émettrice par une diode laser sans focaliser la lumière émise par cette diode, tout en conservant un rendement équivalent à celui du dispositif divulgué dans le bulletin de la Société Nanolase, mentionné plus haut.

L'invention permet en outre d'obtenir un dispositif très compact d'émission de lumière dans le domaine allant de 2 micromètres à 6 micromètres.

Jayaraman et al., IEEE Photonics Techn. Lett., vol. 12, n°12, déc. 2000, décrit le fonctionnement en onde continue de VCSEL à 1310 nm, à mode transverse unique, jusqu'à 115°C ; US 5982802 décrit un microlaser solide à pompage optique par un laser semiconducteur à cavité verticale ; US 5754578 décrit un laser à émission par la surface à cavité verticale à 1250-1650 nm, pompé par un autre laser de ce type, à 700-1050 nm ; et DE 19523267 décrit un module de laser.

De façon précise, la présente invention a pour objet un dispositif d'émission de lumière, conformément à la revendication 1.

Selon un mode de réalisation préféré du dispositif objet de l'invention, la partie active est apte à émettre un rayonnement infrarouge dont la longueur d'onde est comprise dans l'intervalle allant de 2µm à 6µm.

La présente invention concerne aussi des procédés de fabrication du dispositif, conformément aux revendications 3 et 4.

De préférence, la structure émettrice est fixée à la diode laser au moyen d'une colle qui est transparente à la lumière émise par cette diode laser.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1A à lE illustrent schématiquement des étapes d'un mode de mise en oeuvre particulier du procédé objet de l'invention,
- la figure 2 est une vue schématique d'un mode de réalisation particulier du dispositif objet de l'invention,
- les figures 3A et 3B illustrent schématiquement des étapes d'un autre mode de mise en oeuvre particulier du procédé objet de l'invention, et
- la figure 4 est une vue schématique d'un autre mode de réalisation particulier du dispositif objet de l'invention.

### EXPOSÉ DÉTAILLÉ DE MODES DE RÉALISATION PARTICULIERS

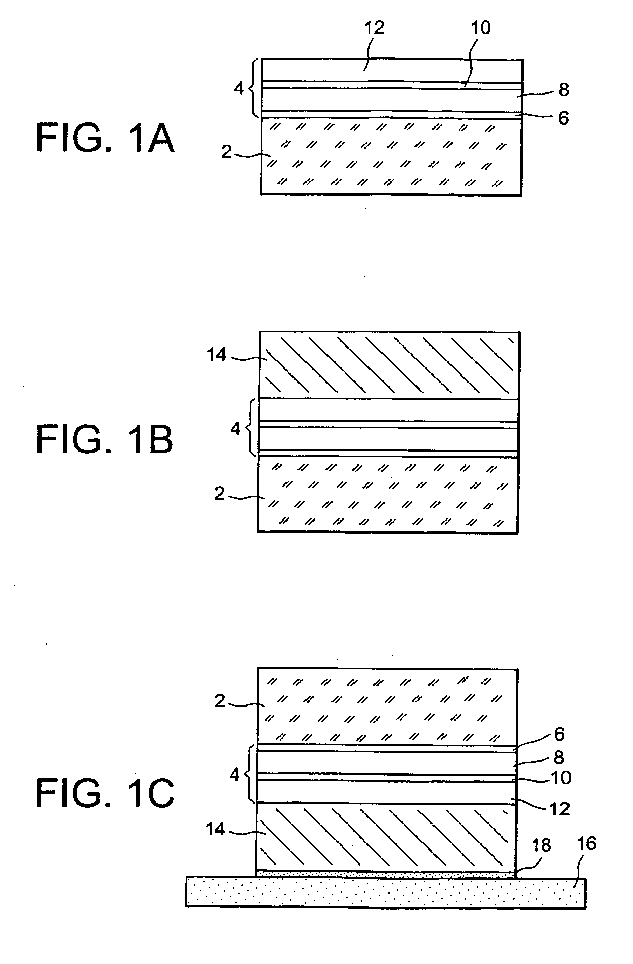

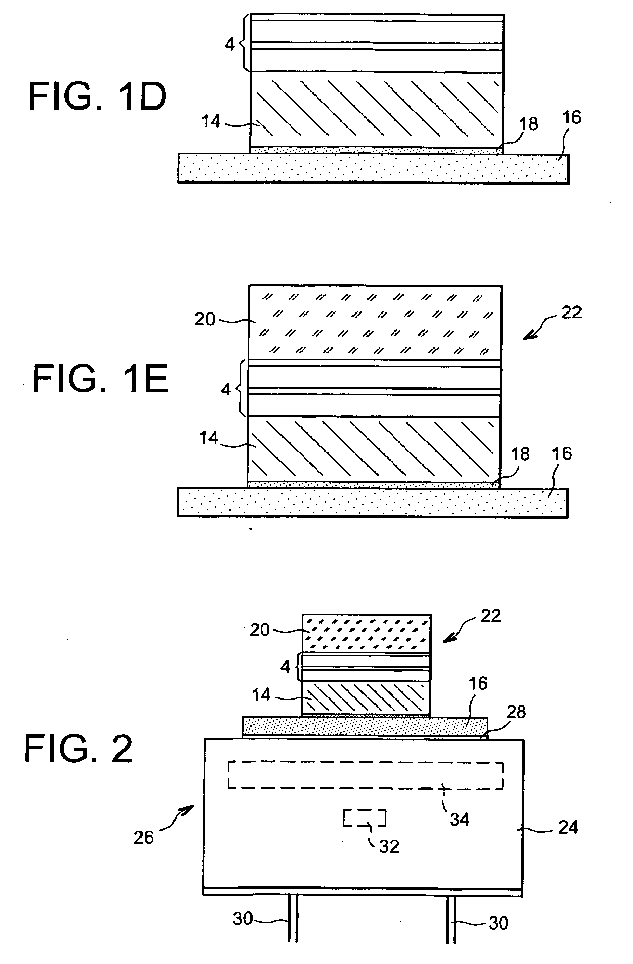

On donne dans ce qui suit un exemple de procédé conforme à l'invention en faisant référence aux figures 1A à lE.

Pour mettre en oeuvre ce procédé, on commence par former, sur un substrat 2 par exemple en CdZnTe (figure lA), une structure émettrice, apte à engendrer un rayonnement infrarouge lorsqu'elle est pompée optiquement.

Le substrat 2 a par exemple une épaisseur de 750µm.

Pour former la structure émettrice, on forme sur le substrat 2, par épitaxie, une partie active 4 à base de CdHgTe. Dans cet exemple, cette partie active est un empilement comprenant successivement une couche 6 de HgTe, une couche 8 de Cd_{0,7}Hg_{0,3}Te, une couche 10 de Cd_{0,3}Hg_{0,7}Te et une couche 12 de Cd_{0,7}Hg_{0,3}Te.

On forme ensuite, sur cette couche 12, un miroir de Bragg 14 (figure 1B) appelé "miroir de fond", dont la réflectivité (vis-à-vis du rayonnement engendré par la partie active) est très grande et par exemple égale à 99%.

On colle ensuite ce miroir de fond 14 sur une lame de silice 16 (figure 1C) dont l'épaisseur vaut par exemple 300µm, au moyen d'une couche de colle 18 qui est transparente à la lumière destinée au pompage optique de la structure émettrice.

On élimine ensuite le substrat 2. On commence par enlever 600µm de ce dernier par polissage mécanique. On grave ensuite chimiquement les 150µm restants (figure 1D). Pour ce faire, on utilise une gravure chimique qui est sélective vis-à-vis de HgTe. Cette gravure est réalisée par un mélange d'acides et s'arrête sur la couche 6.

On forme ensuite un autre miroir de Bragg 20 appelé "miroir de sortie" sur la couche 6, par un dépôt approprié (figure lE).

La réflectivité de ce miroir 20 vaut par exemple 60% vis-à-vis du rayonnement émis par la partie active 4, dont la longueur d'onde vaut par exemple 3,3µm.

On précise que la réflectivité du miroir de fond 14 est très faible vis-à-vis de la lumière de pompage optique dont la longueur d'onde vaut par exemple 1,06µm.

La structure émettrice 22 ainsi obtenue, comportant une micro-cavité délimitée par les miroirs 14 et 20, est ensuite collée sur le boîtier 24 (figure 2) de la diode laser 26 destinée au pompage optique de cette structure. Pour ce faire, on utilise une couche 28 d'une colle qui est transparente à la lumière engendrée par cette diode laser.

On voit aussi sur la figure 2 des électrodes 30 que comporte la diode laser 26 ainsi que la zone émissive 32 de cette diode et le hublot 34 de cette dernière, qui se trouve entre cette zone 32 et la structure émettrice 22.

La distance entre la zone émissive 32 et la structure émettrice 22 vaut par exemple 1mm.

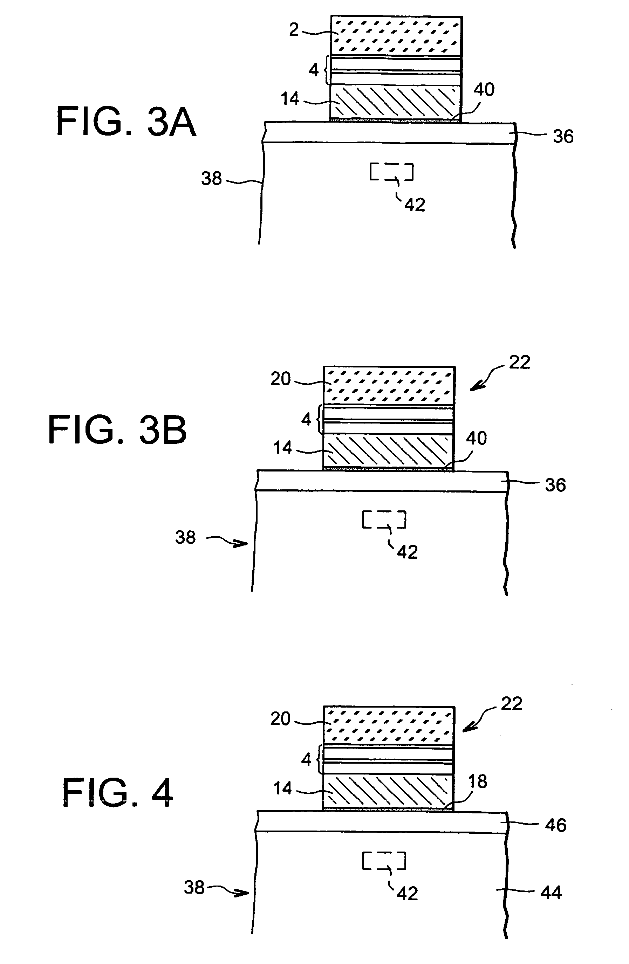

Pour pouvoir utiliser une diode laser de pompage de plus faible puissance, tout en conservant la même densité de puissance, et ainsi augmenter notablement le rendement du dispositif, on supprime la lame de silice 16. Plus précisément, on effectue l'étape de collage du miroir de fond 14 (décrite en faisant référence à la figure 1C) directement sur le hublot 36 d'une diode laser de pompage 38 comme cela est schématiquement illustré par la figure 3A.

On utilise encore, pour ce faire, une couche de colle 40 qui est transparente à la lumière émise par cette diode dont on aperçoit également la zone émissive 42.

Ensuite, après avoir protégé la diode laser 38, on met en oeuvre l'étape de polissage mécanique du substrat 2 puis l'étape de gravure chimique sélective, permettant d'éliminer le reste de ce substrat, puis l'étape de dépôt du miroir de sortie 20 (figure 3B) de la manière expliquée plus haut.

Pour protéger la diode laser de pompage 38, on procède de la façon suivante : on protège cette diode 38 par un masque pendant l'étape de dépôt du matériau du miroir. Ce masque est par exemple en aluminium.

Au lieu de former la structure émettrice sur le hublot, on peut découper le boîtier 44 (figure 4) de la diode laser de pompage 38 afin d'enlever le hublot d'origine puis remplacer ce dernier par une lame de silice 46 ayant les mêmes dimensions que ce hublot d'origine et portant la structure émettrice, cette structure étant préalablement formée puis collée sur cette lame 46 comme on l'a vu plus haut en faisant référence aux figures 1A à lE.

Ce procédé permet de supprimer une étape dans la fabrication du dispositif et aussi d'améliorer d'un facteur 10 le rendement externe de ce dispositif.

A titre purement indicatif et nullement limitatif, la diode laser 38 est du genre de celle qui est commercialisée par la Société Thorlabs Inc. sous la référence HL 7851G.

## Revendications

1. Dispositif d'émission de lumière, ce dispositif comprenant :
- une structure émettrice (22) comprenant une partie active (4) et une micro-cavité, délimitée par des premier et deuxième miroirs (14, 20) et contenant la partie active, et
- une diode (26, 38) laser destinée au pompage optique de la structure émettrice à travers le premier miroir (14) de celle-ci,
dans lequel la structure émettrice (22) est fixée à la diode laser (26,38),
**caractérisé en ce que** la structure émettrice (22) comprend en outre une lame (16) qui est transparente à la lumière engendrée par la diode laser (26) et qui est fixée à cette diode laser.

2. Dispositif selon la revendication 1, dans lequel la partie active (4) est apte à émettre un rayonnement infrarouge dont la longueur d'onde est comprise dans l'intervalle allant de 2 µm à 6 µm.

3. Procédé de fabrication d'un dispositif d'émission de lumière, dans lequel on forme une structure émettrice (22) comprenant une partie active (4) et une micro-cavité, délimitée par des premier et deuxième miroirs (14, 20) et contenant la partie active, on utilise une diode (26, 38) laser destinée au pompage optique de la structure émettrice à travers le premier miroir (14) de celle-ci, et l'on fixe cette structure émettrice à la diode laser (26, 38), dans lequel la structure émettrice (22) comprend en outre une lame (16) qui est transparente à la lumière engendrée par la diode laser et dans lequel on forme la partie active (4) sur un substrat (2) et le premier miroir (14) sur cette partie active, on fixe ce premier miroir sur la lame transparente (16), on élimine le substrat, on forme le deuxième miroir (20) sur la partie active et l'on fixe la lame à la diode laser (26).

4. Procédé de fabrication d'un dispositif d'émission de lumière, dans lequel on forme une structure émettrice comprenant une partie active (4) et une micro-cavité, délimitée par des premier et deuxième miroirs (14, 20) et contenant la partie active, on utilise une diode (26, 38) laser destinée au pompage optique de la structure émettrice à travers le premier miroir (14) de celle-ci, et l'on fixe la structure émettrice à la diode laser, dans lequel la structure émettrice (22) comprend en outre une lame (16) qui est transparente à la lumière engendrée par la diode laser, et dans lequel la diode laser (38) comporte un hublot et l'on forme la partie active (4) sur un substrat (2) et le premier miroir (14) sur cette partie active, on fixe ce premier miroir sur la lame transparente (46), on élimine le substrat, on forme le deuxième miroir (20) sur la partie active, on élimine le hublot et l'on remplace ce hublot par la lame transparente (46).

5. Procédé selon l'une quelconque des revendications 3 et 4, dans lequel la structure émettrice (22) est fixée à la diode laser (26, 38) au moyen d'une colle (18, 40) qui est transparente à la lumière émise par cette diode laser.

## Claims

1. Device for emission of light, this device comprising:
- an emitting structure (22) comprising an active part (4), and a micro-cavity, delimited by first and second mirrors (14, 20) and containing the active part, and
- a laser diode (26, 38) designed for optical pumping of the emitting structure through the first mirror (14) of this structure;
wherein the emitting structure (22) is fixed to the laser diode (26, 38),
**characterized in that** the emitting structure (22) also comprises a plate (16) that is transparent to light generated by the laser diode (26) and that is fixed to this laser diode.

2. Device according to claim 1, in which the active part (4) is able to emit an infrared radiation with a wavelength within the interval from 2 µm to 6µm.

3. Process for manufacturing a device for emission of light, in which one forms an emitting structure (22) comprising an active part (4), and a micro-cavity, delimited by first and second mirrors (14, 20) and containing the active part, one uses a laser diode (26, 38) designed for optical pumping of the emitting structure through the first mirror (14) of this structure, and this emitting structure is fixed to the laser diode (26, 38), in which the emitting structure (22) also comprises a plate (16) that is transparent to light generated by the laser diode and in which the active part (4) is formed on a substrate (2) and the first mirror (14) is formed on this active part, this first mirror is fixed onto the transparent plate (16), the substrate is eliminated, the second mirror (20) is formed on the active part and the plate is fixed to the laser diode (26).

4. Process for manufacturing a device for emission of light, in which one forms an emitting structure comprising an active part (4), and a micro-cavity, delimited by first and second mirrors (14, 20) and containing the active part, one uses a laser diode (26, 38) designed for optical pumping of the emitting structure through the first mirror (14) of this structure, and the emitting structure is fixed to the laser diode, in which the emitting structure (22) also comprises a plate (16) that is transparent to light generated by the laser diode and in which the laser diode (38) comprises a port and the active part (4) is formed on a substrate (2) and the first mirror (14) is formed on this active part, this first mirror is fixed on the transparent plate (46), the substrate is eliminated, the second mirror (20) is formed on the active part, the port is eliminated and this port is replaced by the transparent plate (46).

5. Process as claimed in any of claims 3 and 4, in which the emitting structure (22) is fixed to the laser diode (26, 38) using a glue (18, 40) that is transparent to light emitted by this laser diode.

## Patentansprüche

1. Vorrichtung zur Emission von Licht, umfassend:
- eine Emissionsstruktur (22), welche einen aktiven Teil (4) und einen Mikrohohlraum umfasst, der durch erste und zweite Spiegel (14, 20) begrenzt ist und den aktiven Teil enthält, sowie
- einen Diodenlaser (Laserdiode) (26, 38), der/die zum optischen Pumpen der Emissionsstruktur durch deren ersten Spiegel (14) hindurch bestimmt ist,
und in welcher die Emissionsstruktur (22) an dem Diodenlaser /der Laserdiode (26, 38) befestigt ist,
**dadurch gekennzeichnet, dass** die Emissionsstruktur (22) des weiteren ein Blatt (16) umfasst, das für das durch den Diodenlaser/die Laserdiode (26) erzeugte Licht durchlässig ist und an diesem Diodenlase/dieser Laserdiode befestigt ist.

2. Vorrichtung nach Anspruch 1, bei welcher der aktive Teil (4) eine Infrarot-Strahlung emittieren kann, deren Wellenlänge in dem Intervall von 2 µm bis 6 µm enthalten ist.

3. Verfahren zur Herstellung einer Vorrichtung zur Lichtemission, bei welchem man eine Emissionsstruktur (22) bildet, welche einen aktiven Teil (4) und einen durch erste und zweite Spiegel (14, 20) begrenzten Mikrohohlraum umfasst und den aktiven Teil enthält, unter Verwendung einer Laserdiode/eines Diodenlasers (26, 38), der zum optischen Pumpen der Emissionsstruktur durch deren ersten Spiegel hindurch bestimmt ist, und wobei diese Emissionsstruktur an dem Diodenlaser/der Laserdiode (26, 38) befestigt wird, bei welchem Verfahren die Emissionsstruktur (22) des weiteren ein Blatt (16) umfasst, das für das durch den Diodenlaser/die Laserdiode erzeugt Licht durchlässig ist, und bei welchem man den aktiven Teil (4) auf einem Substrat (2) und den ersten Spiegel auf diesem aktiven Teil ausbildet, bei welchem man diesen ersten Spiegel auf dem durchlässigen Blatt befestigt, bei welchem man des Substrat entfernt, und bei welchem man den zweiten Spiegel (20) auf dem aktiven Teil ausbildet und das Blatt an dem Diodenlaser/ der Laserdiode (26) befestigt.

4. Verfahren zur Herstellung einer Vorrichtung zur Lichtemission, bei welchem man eine Emissionsstruktur ausbildet, welche einen aktiven Teil (4) und einen durch erste und zweite Spiegel (14, 20) begrenzten Mikrohohlraum umfasst und den aktiven Teil enthält, unter Verwendung einer Laserdiode/ eines Diodenlasers (26, 38), die/der zum optischen Pumpen der Emissionsstruktur durch deren ersten Spiegel (14) hindurch bestimmt ist, und wobei die Emissionsstruktur an dem Diodenlaser/ an der Laserdiode befestigt wird, bei welchem Verfahren die Emissionsstruktur (22) des weiteren ein Blatt (16) umfasst, das für das durch den Diodenlaser/ die Laserdiode erzeugte Licht durchlässig ist, und bei welchem der Diodenlaser/ die Laserdiode (38) ein Fenster aufweist, und bei welchem man den aktiven Teil (4) auf einem Suibstrat (2) und den ersten Spiegel (14) auf diesem aktiven Teil ausbildet, bei welchem man diesen ersten Spiegel auf dem durchlässigen Blatt (46) befestigt, bei welchem man das Substrat entfernt, bei welchen man den zweiten Spiegel (20) auf dem aktiven Teil ausbildet, bei welchem man das Fenster entfernt und bei dem man das Fenster durch das durchlässige Blatt (46) ersetzt.

5. Verfahren nach einem beliebigen der Ansprüche 3 und 4, bei welchem die Emissionsstruktur (22) an der Laserdiode/ dem Diodenlaser (26, 38) mittels eines Klebers (18, 40) befestigt ist, der für das von diesem Diodenlaser/ dieser Laserdiode erzeugt Licht durchlässig ist.
